# EUROPEAN PATENT APPLICATION

(11) **EP 3 993 584 A1**
(43) Date of publication of application: **04.05.2022**
(21) Application number: 21202278.4
(22) Date of filing: 12.10.2021
(51) Int. Cl.: H05K 7/14, H05K 5/00

(54) **SEALED ELECTRONIC MODULE PROVIDED WITH IMPROVED FIXING MEANS, AND RELATIVE ASSEMBLY METHOD**

(30) Priority: 27.10.2020 IT 202000025363
(71) Applicant: Marelli Europe S.p.A., 20011 Corbetta (MI) (IT)
(72) Inventor: LO RITO, Gianfranco, I-20011 Corbetta, Milano (IT); MAGGIONI, Davide, I-20011 Corbetta, Milano (IT)
(74) Representative: Mitola, Marco

(57) **Abstract**

A sealed electronic module (4) comprising a printed circuit board (8) having a plurality of electronic components (12), a formed metal sheet (16) which acts as a support and fixing for the printed circuit board (8) by means of at least one fixing means (20), a closing cover (24) which hermetically covers the formed metal sheet and/or the printed circuit board (8) so as to ensure the hermetic seal of the printed circuit board (8) with respect to the outside of the sealed electronic module (4). The at least one fixing means (20) of the printed circuit board (8) on the formed metal sheet (16) comprises at least one mechanical joint (34) which forms a shaped coupling between a male portion (36) and a female portion or seat (40) formed on the printed circuit board (8) and on the formed metal sheet (16) or vice versa; in this way the formed metal sheet (16), at said mechanical joint (34), is without through-holes and communicates with the outside of the sealed electronic module (4).

## Description

### FIELD OF APPLICATION

The present invention relates to a sealed electronic module provided with improved fixing means and to the relative assembly method.

### PRIOR ART

In the automotive sector, it is known to produce electronic modules, typically electronic control units, which are housed in the engine compartment and which are therefore subject to considerable mechanical and thermal stresses during their operation.

Furthermore, the motor compartments are not hermetically sealed so the electronic modules are also subject to the action of water and humidity which, as is known, in the event of infiltration inside the module, may create problems in the functioning of the electronic components contained therein and fixed on a special printed circuit board.

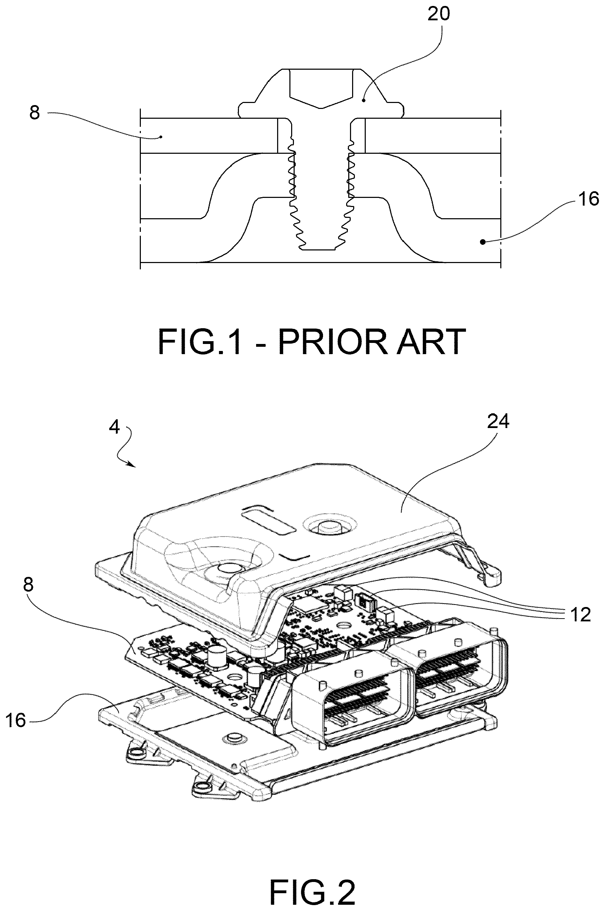

Electronic modules with formed metal sheet metal housing exhibit the problem of humidity and/or water infiltration in particular, since the fixing of the printed circuit board is normally carried out by means of screws passing through special holes made on the printed circuit board and on the formed metal sheet (Figure 1).

As is known, the screws do not allow a tight fixing since there is inevitable clearance between the threads of the screw and the nut screw which also increase due to the different thermal deformations of the components connected to each other: in fact, typically the screws and the formed metal sheet are made of metallic materials different from each other and therefore have different coefficients of thermal expansion.

To overcome this drawback, it is known, for example, to use thread locking pastes or special sealing bushings: however, these solutions are not able to guarantee a perfect seal over time, taking into account that these electronic modules must maintain their hermetic sealing qualities unchanged over a period of several years, even if subjected to severe conditions of use in terms of mechanical and thermal stress.

### DISCLOSURE OF THE INVENTION

Thus, there is a need in the art to resolve the cited drawbacks and limitations in reference to the prior art.

Such a need is met by a sealed electronic module according to claim 1 and by a method of assembling a sealed electronic module according to claim 11.

Other embodiments of this invention are described in the dependent claims.

### DESCRIPTION OF THE DRAWINGS

Further features and advantages of this invention will become more apparent from the following detailed description of preferred, non-limiting embodiments thereof, wherein:
- Figure 1 shows a sectional view of an embodiment of the prior art;
- Figure 2 shows a perspective exploded view of a sealed electronic module according to an embodiment of the present invention;

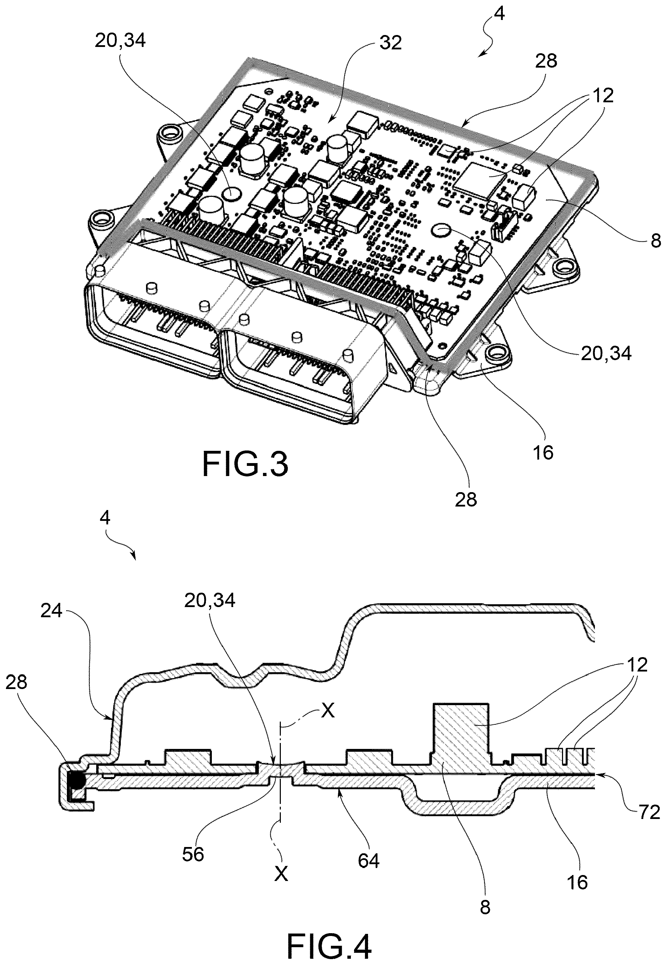

- Figure 3 shows a perspective view of some components of the electronic module of Figure 1, without a closing cover;
- Figure 4 shows a sectional view, in assembly configuration, of the electronic module of Figure 2;
- Figure 5 shows a plan view of the electronic module of Figure 3;
- Figures 6a-6b-7-8 show sectional views of successive steps for creating a connection joint by plastic deformation, according to an embodiment of the present invention;
- Figure 9 shows a perspective view of a male portion of a mechanical joint according to a possible embodiment of the present invention;
- Figures 10-12 show plan views of electronic modules, without closing cover, according to different embodiments of the mechanical connection joints between the printed circuit board and the formed metal sheet.

Elements or parts of elements common to the embodiments described hereinafter will be indicated with the same numerical references.

### DETAILED DESCRIPTION

With reference to the aforesaid figures, the reference numeral 4 globally indicates a sealed electronic module, in particular, but not exclusively, suitable for use in the automotive sector.

It is noted that the application of the present invention to the automotive sector is preferential, but not exclusive, since the sealed electronic module may have various fields of use.

The sealed electronic module 4 comprises a printed circuit board 8 having a plurality of electronic components 12 and a formed metal sheet 16 which acts as a support and fixing for the printed circuit board 8 by means of at least one fixing means 20.

The sealed electronic module 4 further comprises a closing cover 24 which covers the formed metal sheet 16 and/or the printed circuit board 8 in such a way as to ensure the hermetic seal of the printed circuit board 8 with respect to the outside of the sealed electronic module 4.

The formed metal sheet is usually made of aluminum or steel; the closing cover 24 may be made either of metal or plastic material.

In order to guarantee the hermetic seal of its interior, the sealed electronic module 4 comprises a perimeter sealing gasket 28 placed between the closing cover 24 and the formed metal sheet 16 that delimits an area 32 of the printed circuit board 8 containing said electronic components 12. For example, a dispensed resin or even a gasket made of polymeric material may be used as the perimeter sealing gasket 28.

Advantageously, the at least one fixing means 20 of the printed circuit 8 onto the formed metal sheet 16 comprises at least one mechanical joint 34 which forms a shaped coupling between a male portion 36 and a female portion or seat 40 made on the printed circuit board 8 and on the formed metal sheet 16 or vice versa.

In other words, the male portion 36 and the female portion 40 may be obtained on the formed metal sheet 16 and on the printed circuit board 8, respectively, or vice versa.

Advantageously, the formed metal sheet 16, at said mechanical joint 34, is without through-holes communicating with the outside of the sealed electronic module 4. In this way there is no possibility for water or humidity to enter the sealed electronic module 4 through the mechanical joint 34 between the formed metal sheet 16 and the printed circuit board 8.

According to an embodiment, said mechanical joint 34 is a plastic deformation joint between a male portion 36 of the formed metal sheet 16, housed in a female portion 40 of the printed circuit board 8 having a through-hole 48 along an assembly direction X-X.

The male portion 36 has at least one cantilevered element 52 at its top 44 which protrudes at least partially from the seat along said assembly direction X-X, which forms an undercut with respect to said assembly direction X-X.

According to an embodiment, said cantilevered element 52 is a crown or circumferential edge which forms an undercut with respect to said assembly direction X-X.

Preferably, the male portion 36 and the female portion 40 are counter-shaped to each other.

For example, the male portion 36 and the female portion 40 are axially symmetrical with respect to an axis of symmetry parallel to said assembly direction X-X.

The male portion 36 may have various geometries, with respect to a section plane perpendicular to said assembly direction X-X.

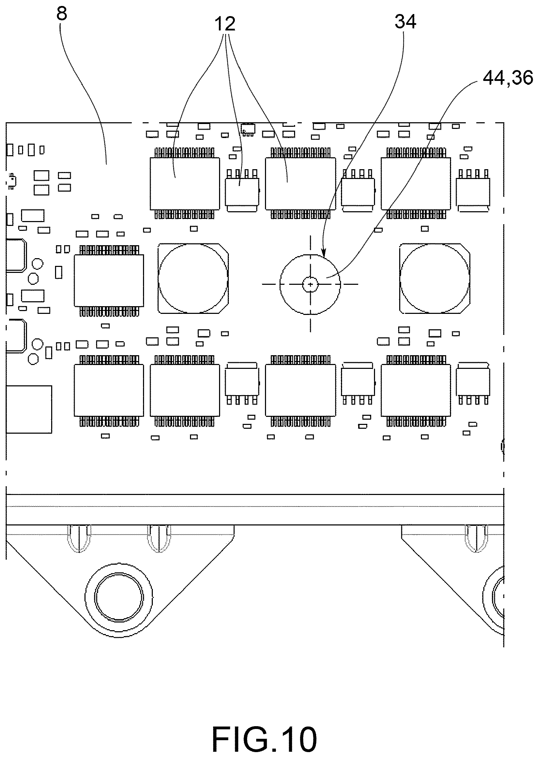

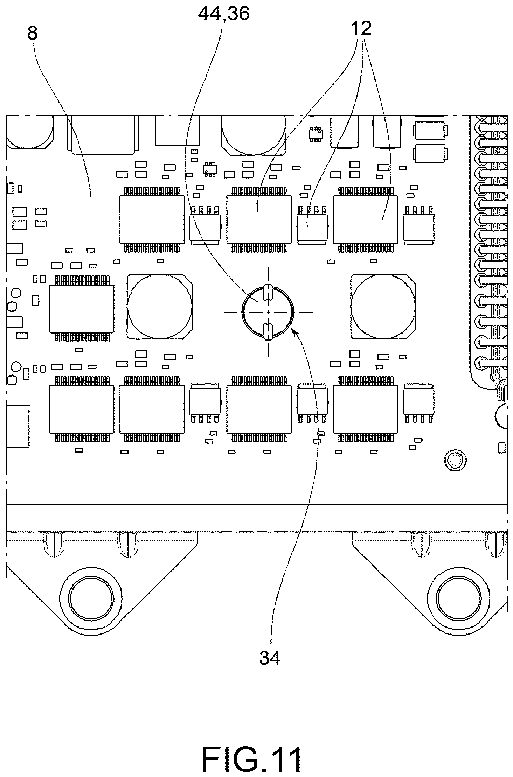

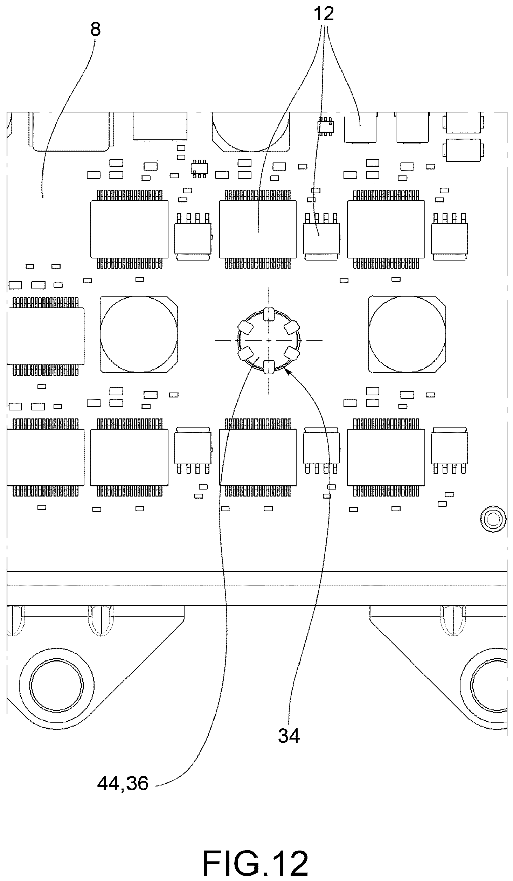

For example, the male portion 36 may have a flat section (Figure 10), a shear section (Figure 11) or a hexalobular section (Figure 12).

The examples of geometries shown above are purely indicative and not exhaustive. It is therefore possible to use further geometries for said male portions 36.

It is also possible to configure the male portion 36 and the female portion 40 so as to make a snap coupling. For example, it is possible to make a slightly forced coupling, i.e. with interference, between the male portion 36 and the female portion, so as to obtain a solid mechanical joint after forcing the insertion and passage of the top 44 of the male portion 36 through the female portion or seat of the printed circuit board 8.

According to a preferred embodiment, the male portion 36 of the mechanical joint 34 has a recess 56 on the opposite side to the associable female portion or seat 40.

Said recess allows a coupling with an associable punch, as better described below, and allows a more precise control of the plastic deformation of the top 44 of the male portion 36.

Preferably, the male portion 36 is obtained on the formed metal sheet 16 by plastic deformation of the formed metal sheet itself and therefore has the same thickness as the formed metal sheet 16 with respect to the assembly direction X-X.

The coupling method and the relative operation of a sealed electronic module according to the present invention will now be described.

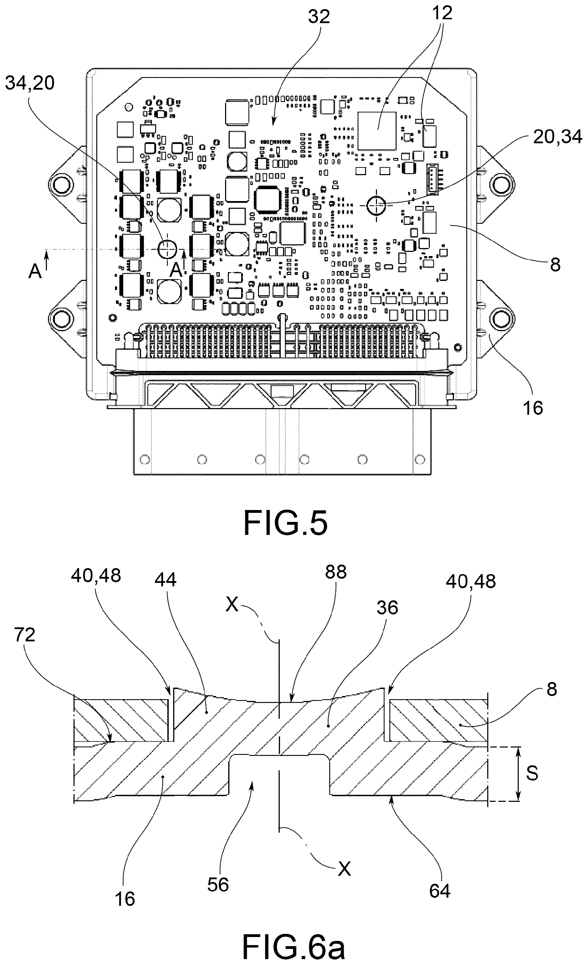

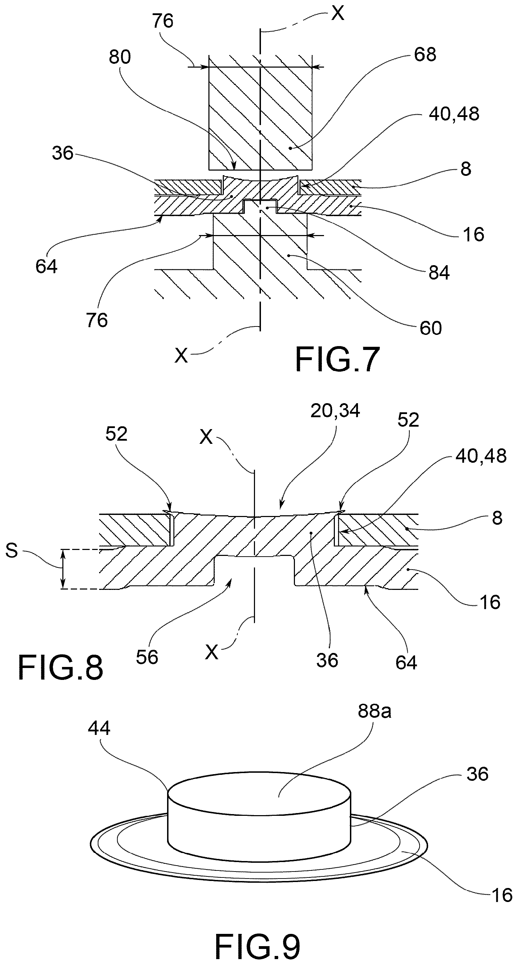

In particular, the assembly method of the sealed electronic module 4 comprises the steps of:
- providing a printed circuit board 8 having a plurality of electronic components 12,
- providing a formed metal sheet 16 which acts as a support and fixing for the printed circuit board 8 by means of at least one fixing means 20,
- providing a closing cover 24 which covers the formed metal sheet 16 and/or the printed circuit board 8 in such a way as to ensure the hermetic seal of the printed circuit board 8 with respect to the outside of the sealed electronic module 4,
- preforming at least one fixing means 20 of the printed circuit board 8 on the formed metal sheet 16 by cold forming the formed metal sheet 16 using a punch so as to obtain a male portion 36, without through-holes and communicating with the outside,
- providing at least one hole or seat 40, which acts as a female portion 40, on the printed circuit board 8,
- engaging the male portion 36 in said hole or seat 40 in an assembly direction X-X, so as to have a top 44 of the male portion 36 coming out at least partially from the seat 40 along said assembly direction X-X (Figures 6a-6b),
- plastically deforming said top 44 of the male portion 36 so as to create a mechanical joint 34 by means of an undercut with respect to said assembly direction X-X (Figures 7-8).

According to a possible embodiment, the plastic deformation occurs through the use of a first punch 60 arranged on a lower face 64 of the formed metal sheet 16, opposite the associable printed circuit board 8, and a second punch 68 arranged on an upper face 72 of the formed metal sheet 16, on the side opposite the lower face 64.

Preferably, said first punch 60 and second punch 68 have an amplitude or area 76 greater than the amplitude or area of the male portion 36, said amplitudes being measured on a projection plane perpendicular to the assembly direction X-X.

According to a possible embodiment, the second punch 68 has a flat abutment face 80 suitable for deforming the top 44 of the male portion 36.

According to a possible embodiment, the first punch 60 has a stepped abutment face 84 which is counter-shaped with respect to the lower face 64 of the formed metal sheet 16.

Preferably, the step of preparing the formed metal sheet 16 comprises the step of:
- preparing an initially flat formed sheet 16 having a thickness S,
- preforming at least one male portion 36 of the formed metal sheet 16 by plastic deformation of the formed metal sheet 16 by punching, so that the male portion 36 has substantially the same thickness S as the formed metal sheet 16.

Preferably, said preformed male portion 36 has a concavity or concavity 88a, 88b at a top 44 thereof intended to be inserted into a matching seat of the printed circuit board 8. Such concavity or convexity 88a, 88b facilitates the subsequent plastic deformation of the top 44 so that the cantilevered element 52 which forms the locking undercut between the printed circuit board 8 and the formed metal sheet 16 is created.

In particular, by using a male portion 36 having a non-flat top 44, in particular having a concavity 88a or a convexity 88b, the effect is obtained whereby the forces exerted by the abutment face 80 of the second punch 68 are concentrated on a limited surface.

In this way, the plastic deformation of the top 44 of the male portion 36 is obtained, so that it creates an undercut and therefore the fixing of the printed circuit board 8 on the formed metal sheet 16, applying a limited force to the second punch. It is in fact important to expose the printed circuit board 8 as little as possible to compressive loads in order to not compromise the operation of the delicate electronic components 12 applied therein.

In particular, in the case of use of a male portion 36 with top 44 provided with a concavity 88a (Figure 6a), the abutment face 80 of the second punch 68 will directly (and substantially exclusively) impact the circumferential edge of the top 44 of the male portion 36 which may easily deform, flowing plastically around the portion of printed circuit board 8 adjacent to the through-hole 48.

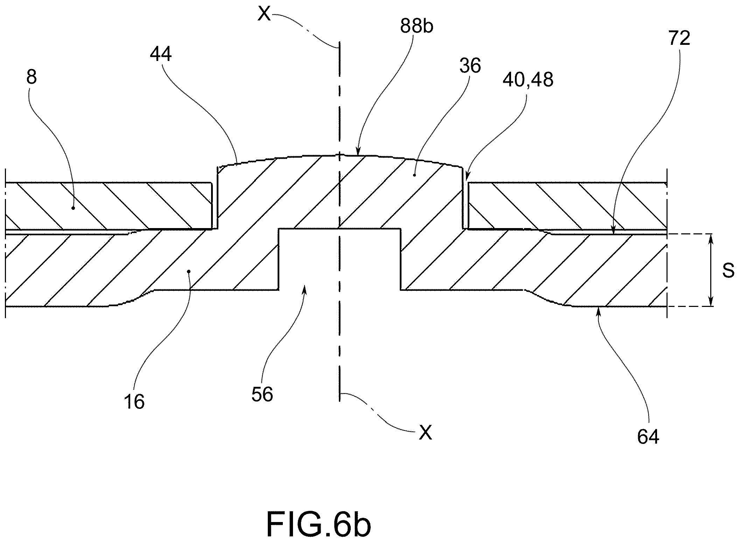

In the case of use of a male portion 36 with a top 44 provided with a convexity 88b (Figure 6b), the abutment face 80 of the second punch 68 will directly (and substantially exclusively) impact a central portion of the top 44 of the male portion 36 which may easily deform, discharging radially towards the edge and flowing plastically around the portion of printed circuit board 8 adjacent to the through-hole 48.

As may be appreciated from that which is described, the present invention overcomes the drawbacks of the prior art.

In particular, the sealed electronic module according to the present invention does not allow any entry of water or humidity since the means for fixing the printed circuit board to the formed metal sheet do not provide holes passing through the formed metal sheet: in this way there is no possibility of passage of water or humidity except through the couplings between the closing cover and the sheet which are however hermetically sealed.

Advantageously, the plastic deformation fixing means allow the printed circuit board to be locked in position without subjecting it to excessive mechanical stresses which would compromise the functionality thereof: in fact, the controlled deformation joint according to the present invention may be made by applying a force of a few hundred Newton (typically below 500 N) which does not compromise or deform the printed circuit board and its electronic components in any way.

For this purpose, as seen, it is possible to use specific geometries of the male portions of the mechanical joints in order to reduce as much as possible the force to be applied to the punch to plastically deform the top of the male portion and create the undercut that fixes the printed circuit board to the formed metal sheet.

Furthermore, the controlled deformation joint is particularly resistant to the thermal and mechanical stresses (vibrations) to which the electronic module is subjected in automotive applications.

In particular, the vibrations are in no way capable of breaking or even loosening the joint made, as could instead occur in the case of using the threaded connection means of the prior art.

Furthermore, the thermal stresses to which the joint is subjected are not able to loosen it or even to create possible infiltrations as would occur in the case of threaded connections of the prior art.

In fact, the joint is absolutely solid and, even in the event of thermal expansion, there is no risk of water and/or humidity infiltrations since the joint does not have through-holes which may place the electronic module in communication with the external environment.

The advantage is given by the fact that the joint of the present invention has only the purpose of the mechanical connection between the printed circuit board and the formed metal sheet and has no hermetic sealing function; on the other hand, in known solutions the threaded joints have both the function of mechanical connection and the function of hermetic sealing.

The solution of the present invention does not constitute an increase in the number of components and therefore in the assembly/production costs of the electronic module since it does not provide additional sealing means with respect to the solutions of the prior art: in fact, the hermetic seal is relegated to the perimeter sealing gasket between the printed circuit board and the closing cover, in any case provided in the sealed electronic modules of the prior art.

Furthermore, the joint of the present invention may be easily deformed to allow the opening and disassembly of the electronic module in the case of maintenance operations. Furthermore, such deformation may be of the reversible type.

Finally, the present invention also allows the overall dimensions or the thicknesses of the electronic modules to be reduced compared to known solutions which use connection screws between the formed metal sheet and the printed circuit board: in fact, in the solutions with screws, the thickness of the printed circuit board is added to that of the formed metal sheet provided with respective elevations to house the thread of the nut screw and the screw, while in the present invention the raised plate of the formed metal sheet is housed in the hole or seat of the printed circuit board, therefore it does not increase the overall thickness of the module.

A person skilled in the art may make several changes and adjustments to the electronic modules and to the assembly methods described above in order to meet specific and incidental needs, all falling within the scope of protection defined in the following claims.

## Claims

1. Sealed electronic module (4) comprising:
- a printed circuit board (8) having a plurality of electronic components (12),
- a formed metal sheet (16) which acts as a support and fixing for the printed circuit board (8) by means of at least one fixing means (20),
- a closing cover (24) which covers the formed metal sheet and/or the printed circuit board (8) in such a way as to ensure the hermetic seal of the printed circuit board (8) with respect to the outside of the sealed electronic module (4),
wherein
- said at least one fixing means (20) of the printed circuit (8) onto the formed metal sheet (16) comprises at least one mechanical joint (34) which forms a shaped coupling between a male portion (36) and a female portion or seat (40) made on the printed circuit board (8) and on the formed metal sheet (16) or vice versa,
- wherein the formed metal sheet (16), at said mechanical joint (34), is without through holes communicating with the outside of the sealed electronic module (4).

2. The sealed electronic module (4) according to claim 1, wherein said mechanical joint (34) is a plastic deformation mechanical joint (34) between a male portion (36) of the formed metal sheet (16), housed in a female portion (40) of the printed circuit board (8) having a through-hole along an assembly direction (X-X).

3. The sealed electronic module (4) according to claim 2, wherein the male portion (36) has at least one cantilevered element (52) at its top (44) which protrudes at least partially from the seat (40) along said assembly direction (X-X), which forms an undercut with respect to said assembly direction (X-X).

4. The sealed electronic module (4) according to claim 3, wherein said cantilevered element (52) is a crown or circumferential edge which forms an undercut with respect to said assembly direction (X-X).

5. The sealed electronic module (4) according to any of the claims from 1 to 4, wherein the male portion (36) and the female portion (40) are counter-shaped to each other.

6. The sealed electronic module (4) according to any of the claims from 1 to 5, wherein the male portion (36) and the female portion (40) are axially symmetrical with respect to an axis of symmetry parallel to said assembly direction (X-X).

7. The sealed electronic module (4) according to any of the claims from 1 to 6, wherein the male portion (36) and the female portion (40) are configured to make a snap coupling.

8. The sealed electronic module (4) according to any of the claims from 1 to 7, wherein the electronic module (4) comprises a perimeter sealing gasket (28) placed between the closing cover (24) and the formed metal sheet (16) that delimits an area (32) of the printed circuit board (8) containing said electronic components (12).

9. The sealed electronic module (4) according to any of the claims from 1 to 8, wherein the male portion (36) of the mechanical joint (34) has a recess (56) on the opposite side to the associable female portion or seat (40) .

10. The sealed electronic module (4) according to any of the claims from 1 to 9, wherein the male portion (36) is made on the formed metal sheet (16) by plastic deformation of the formed metal sheet (16) and has the same thickness (S) as the formed metal sheet (16) in the assembly direction (X-X).

11. Method of assembling a sealed electronic module (4) comprising the steps of:
- providing a printed circuit board (8) having a plurality of electronic components (12),
- providing a formed metal sheet (16) which acts as a support and fixing for the printed circuit board (8) by means of at least one fixing means (20),
- providing a closing cover (24) which covers the formed metal sheet (16) and/or the printed circuit board (8) in such a way as to ensure the hermetic seal of the printed circuit board (8) with respect to the outside of the sealed electronic module (4),
wherein the method is **characterized in that** it comprises the following steps:
- preforming at least one fixing means (20) of the printed circuit board (8) on the formed metal sheet (16) by cold forming the formed metal sheet (16) using a punch so as to obtain a male portion (36), without through-holes and communicating with the outside,
- providing at least one hole or seat (40) on the printed circuit board (8),
- engaging the male portion (36) in said hole or seat (40) in an assembly direction (X-X), so as to have a top (44) of the male portion (36) coming out at least partially from the seat (40) along said assembly direction (X-X),
- plastically deforming said top (44) of the male portion (36) so as to create a mechanical joint (34) by means of an undercut with respect to said assembly direction (X-X) .

12. The assembly method of a sealed electronic module (4) according to claim 11, wherein the plastic deformation of the top (44) of the male portion (36) takes place through the use of a first punch (60) placed on a lower face (64) of the formed metal sheet (16), opposite the associated printed circuit board (8), and a second punch (68) placed on an upper face (72) of the formed metal sheet (16), opposite the lower face (64).

13. The assembly method of a sealed electronic module (4) according to claim 12, wherein said first punch (60) and second punch (68) have an amplitude (76) greater than the amplitude of the male portion, said amplitudes (76) being measured on a projection plane perpendicular to the assembly direction (X-X).

14. The assembly method of a sealed electronic module (4) according to claim 12 or 13, wherein the second punch (68) has a flat abutment face suitable for deforming the top (44) of the male portion (36).

15. The assembly method of a sealed electronic module (4) according to claim 12, 13 or 14, wherein the first punch (60) has a stepped abutment face (80) counter-shaped with respect to the lower face (64) of the formed metal sheet (16) .

16. The assembly method of a sealed electronic module (4) according to any of the claims from 12 to 15, wherein the phase of preparing the formed metal sheet (16) provides for the step of:
- preparing an initially flat formed sheet (16) having a thickness (S),
- preforming at least one male portion (36) of the formed metal sheet (16) by plastic deformation of the formed metal sheet (16) by punching, the male portion (36) having the same thickness (S) as the formed metal sheet (16) .

17. The assembly method of a sealed electronic module (4) according to any of the claims from 12 to 16, wherein said preformed male portion (36) has a concavity or convexity (88) at its top (44) designed to be inserted into a matching seat or female portion (40) of the printed circuit board (8).

18. The assembly method of a sealed electronic module (4), according to any of the claims from 12 to 17, comprising the step of providing a sealed electronic module (4) according to any of the claims from 1 to 10.
